# EUROPEAN PATENT APPLICATION

(11) **EP 2 187 446 A2**
(43) Date of publication of application: **19.05.2010**
(21) Application number: 09170103.7
(22) Date of filing: 11.09.2009
(51) Int. Cl.: H01L 31/0368, H01L 31/075, H01L 31/18, C23C 16/32, C23C 16/34, C23C 16/40, C23C 16/42, H01L 31/0392

(54) **Microcrystalline silicon alloys for thin film and wafer based solar applications**

(30) Priority: 11.09.2008 US 208478
(71) Applicant: Applied Materials, Inc., Santa Clara, CA 95054 (US)
(72) Inventor: Sheng, Shuran, Cupertino, CA 95014 (US); Chae, Yong-Kee, Pleasanton, CA 94588 (US)
(74) Representative: Zimmermann, Gerd Heinrich

(57) **Abstract**

A method and apparatus for forming solar cells is provided. Doped crystalline semiconductor alloys including carbon, oxygen, and nitrogen are used as charge collection layers for thin-film solar cells. The semiconductor alloy layers are formed by providing semiconductor source compound and a co-component source compound to a processing chamber and ionizing the gases to deposit a layer on a substrate. The alloy layers provide improved control of refractive index, wide optical bandgap, high conductivity, and resistance to attack by oxygen.

## Description

### BACKGROUND OF THE INVENTION

### Field of the Invention

Embodiments of the present invention generally relate to solar cells and methods and apparatuses for forming the same. More particularly, embodiments of the present invention relate to layer structures in thin-film and crystalline solar cells.

### Description of the Related Art

Crystalline silicon solar cells and thin film solar cells are two types of solar cells. Crystalline silicon solar cells typically use either mono-crystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-n junctions. Suitable substrates include glass, metal, and polymer substrates.

To expand the economic uses of solar cells, efficiency must be improved. Solar cell efficiency relates to the proportion of incident radiation converted into useful electricity. To be useful for more applications, solar cell efficiency must be improved beyond the current best performance of approximately 15%. With energy costs rising, there is a need for improved thin film solar cells and methods and apparatuses for forming the same in a factory environment.

### SUMMARY OF THE INVENTION

In light of the above, the method according to independent claim 1, the method according to independent claim 5, the photovoltaic device according to independent claim 10, and the photovoltaic device according to independent claim 13 are provided.

Further advantages, features, aspects and details are evident from the dependent claims, the description and the drawings.

Embodiments of the invention provide methods of forming solar cells. Some embodiments provide a method of making a solar cell, comprising forming a conductive layer on a substrate, and forming a p-type crystalline semiconductor alloy layer on the conductive layer. Some embodiments of the invention may also include amorphous or intrinsic semiconductor layers, n-type doped amorphous or crystalline layers, buffer layers, degeneratively doped layers, and conductive layers. A second conductive layer may be formed on an n-typed crystalline layer.

Alternate embodiments provide a method of forming a solar cell, comprising forming a conductive layer on a substrate, forming a first doped crystalline semiconductor alloy layer on the conductive layer, and forming a second doped crystalline semiconductor alloy layer over the first doped crystalline semiconductor alloy layer. Some embodiments may also include undoped amorphous or crystalline semiconductor layers, buffer layers, degeneratively doped layers, and conductive layers. Some embodiments may also include a third and fourth doped crystalline semiconductor alloy layers in a tandem-junction structure.

Further embodiments provide a method of forming a solar cell, comprising forming a reflective layer on a semiconductor substrate, and forming a crystalline junction over the reflective layer, wherein the reflective layer comprises one or more crystalline semiconductor alloy layers.

In an embodiment, a method and apparatus for forming solar cells is provided. Doped crystalline semiconductor alloys including carbon, oxygen, and nitrogen are used as charge collection layers for thin-film solar cells. The semiconductor alloy layers are formed by providing semiconductor source compound and a co-component source compound to a processing chamber and ionizing the gases to deposit a layer on a substrate. The alloy layers provide improved control of refractive index, wide optical bandgap, high conductivity, and resistance to attack by oxygen.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above-recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a schematic side-view of a single-junction thin-film solar cell according to one embodiment of the invention.

Figure 2 is a schematic side-view of a tandem-junction thin-film solar cell according to another embodiment of the invention.

Figure 3 is a schematic side-view of a single-junction thin-film solar cell according to another embodiment of the invention.

Figure 4 is a schematic side-view of a tandem-junction thin-film solar cell according to another embodiment of the invention.

Figure 5 is a schematic side-view of a crystalline solar cell according to another embodiment of the invention.

Figure 6 is a cross-sectional view of an apparatus according to one embodiment of the invention.

Figure 7 is a plan view of an apparatus according to another embodiment of the invention.

Figure 8 is a schematic side-view of a tandem-junction thin-film solar cell according to another embodiment.

Figure 9 is a schematic side-view of a triple-junction thin-film solar cell according to another embodiment of the invention.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

Thin-film solar cells incorporate numerous types of films put together in many different ways. Most films used in such devices incorporate a semiconductor element, such as silicon, germanium, and the like. Characteristics of the different films include degrees of crystallinity, dopant type and quantity, and conductivity. Most such films may be formed by chemical vapor deposition processes, which may include some degree of ionization or plasma formation.

### FILMS USED IN SOLAR CELLS

Charge generation is generally provided by a bulk semiconductor layer, such as a silicon layer. The bulk layer is also sometimes called an intrinsic layer to distinguish from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon" may refer to any form of silicon having a crystal phase, including microcrystalline and nanocrystalline silicon.

Bulk silicon layers are generally formed by providing a silicon source compound to a processing chamber containing a substrate. The substrate is generally disposed on a support in the processing chamber for exposure to the silicon source compound. A gas mixture comprising the silicon source compound is introduced to the chamber. In many instances, the silicon source compound is silane, but other compounds, such as substituted silanes, oligo- or poly- silanes, and cyclic silanes may be used as well. Some suitable silicon source compounds are silane (SiH₄), disilane (Si₂H₆), silicon tetrafluoride (SiF₄), silicon tetrachloride (SiCl₄), and dichlorosilane (SiH₂Cl₂). Hydrogen gas may be provided as well to control the degree of crystallinity, which will generally rise and fall with the ratio of hydrogen to silicon in the gas mixture. Inert gases may also be used to control the overall reaction by diluting or concentrating the reactants. The reactants may also be activated by ionization to increase rate of reaction and lower the temperature required for film formation. Bulk silicon or semiconductor is frequently referred to as "intrinsic" to distinguish from "extrinsic" semiconductor which has been doped.and has properties different from those of intrinsic semiconductor.

An intrinsic silicon layer may be formed in some embodiments by providing a gas mixture comprising silane and hydrogen gas to a processing chamber containing a substrate. The gas mixture may be provided at a flow rate between about 0.5 standard cubic centimeters per minute per liter of reaction volume (sccm/L) and about 1000 sccm/L, with the ratio of hydrogen to silane being between about 5:1 and about 500:1, or more. The reaction volume is generally defined by the processing chamber in which the reaction is performed. In many embodiments, the reaction volume is defined by the walls of the chamber, the substrate support, and the gas distributor, which is generally disposed over the substrate support. The ratio of hydrogen gas to silane is theoretically unlimited, but as the ratio increases in a given reaction, the deposition rate decreases because availability of silicon limits the rate of reaction. Deposition performed with a hydrogen-to-silane ratio of about 50 or less may result in deposition of an amorphous silicon layer. At ratios of 12 of less, the layer is generally amorphous. Silicon layers having less than about 30% crystallinity are generally called amorphous. Deposition performed with a hydrogen-to-silane ratio of about 100 or more will generally result in a deposited film having crystallinity fraction of about 60% or more. Precise transition points will naturally also depend on other reaction conditions like temperature and pressure. In some embodiments, it may be advantageous to vary the ratio during deposition to adjust the crystallinity fraction in different parts of the deposited film. For example, it may be desirable to deposit a bulk silicon layer and a buffer layer in one deposition by changing the reaction conditions during deposition.

Chamber pressure may be maintained between about 0.1 Torr and about 100 Torr. Higher pressures will generally promote deposition rate and crystallinity, but more power will be required to maintain a given degree of ionization of the reactants. Thus, a pressure between about 4 Torr and about 12 Torr is preferred for most embodiments. Applying RF power between about 15 milliwatts per square centimeter of substrate area (mW/cm²) and about 500 mW/cm² will generally result in deposition of intrinsic silicon at a rate 100 Angstroms per minute (Å/min) or better.

An intrinsic amorphous silicon layer may be deposited by providing a gas mixture of hydrogen gas to silane gas in a ratio of about 20:1 or less. Silane gas may be provided at a flow rate between about 0.5 sccm/L and about 7 sccm/L. Hydrogen gas may be provided at a flow rate between about 5 sccm/L and 60 sccm/L. An RF power between 15 mW/cm² and about 250 mW/cm² may be provided to the showerhead. The pressure of the chamber may be maintained between about 0.1 Torr and 20 Torr, preferably between about 0.5 Torr and about 5 Torr. The deposition rate of the intrinsic type amorphous silicon layer will be about 100 Å/min or more. In an exemplary embodiment, the intrinsic type amorphous silicon layer is deposited at a hydrogen to silane ratio at about 12.5:1.

A p-i buffer type intrinsic amorphous silicon (PIB) layer may be deposited by providing a gas mixture of hydrogen gas to silane gas in a ratio of about 50:1 or less, for example, less than about 30:1, for example between about 20:1 and about 30:1, such as about 25:1. Silane gas may be provided at a flow rate between about 0.5 sccm/L and about 5 sccm/L, such as about 2.3 sccm/L. Hydrogen gas may be provided at a flow rate between about 5 sccm/L and 80 sccm/L, such as between about 20 sccm/L and about 65 sccm/L, for example about 57 sccm/L. An RF power between 15 mW/cm² and about 250 mW/cm², such as between about 30 mW/cm² may be provided to the showerhead. The pressure of the chamber may be maintained between about 0.1 Torr and 20 Torr, preferably between about 0.5 Torr and about 5 Torr, such as about 3 Torr. The deposition rate of the PIB layer will be about 100 Å/min or more.

An intrinsic type microcrystalline silicon layer may be deposited by providing a gas mixture of silane gas and hydrogen gas in a ratio of hydrogen to silane between about 20:1 and about 200:1. Silane gas may be provided at a flow rate between about 0.5 sccm/L and about 5 sccm/L. Hydrogen gas may be provided at a flow rate between about 40 sccm/L and about 400 sccm/L. In certain embodiments, the silane flow rate may be ramped up from a first flow rate to a second flow rate during deposition. In certain embodiments, the hydrogen flow rate may be ramped down from a first flow rate to a second flow rate during deposition. Applying RF power between about 300 mW/cm² or greater, preferably 600 mW/cm² or greater, at a chamber pressure between about 1 Torr and about 100 Torr, preferably between about 3 Torr and about 20 Torr, more preferably between about 4 Torr and about 12 Torr, will generally deposit an intrinsic type microcrystalline silicon layer having crystalline fraction between about 20 percent and about 80 percent, preferably between 55 percent and about 75 percent, at a rate of about 200 Å/min or more, preferably about 500 Å/min. In some embodiments, it may be advantageous to ramp the power density of the applied RF power from a first power density to a second power density during deposition.

An intrinsic type microcrystalline silicon layer may be deposited in multiple steps, each having different crystal fraction. In one embodiment, for example, the ratio of hydrogen to silane may be reduced in four steps from 100:1 to 95:1 to 90:1 and then to 85:1. In one embodiment, silane gas may be provided at a flow rate between about 0.1 sccm/L and about 5 sccm/L, such as about 0.97 sccm/L. Hydrogen gas may be provided at a flow rate between about 10 sccm/L and about 200 sccm/L, such as between about 80 sccm/L and about 105 sccm/L. In an exemplary embodiment wherein the deposition has multiple steps, such as four steps, the hydrogen gas flow may start at about 97 sccm/L in the first step, and be gradually reduced to about 92 sccm/L, 88 sccm/L, and 83 sccm/L respectively in the subsequent process steps. Applying RF power between about 300 mW/cm² or greater, such as about 490 mW/cm² at a chamber pressure between about 1 Torr and about 100 Torr, for example between about 3 Torr and about 20 Torr, such as between about 4 Torr and about 12 Torr, such as about 9 Torr, will result in deposition of an intrinsic type microcrystalline silicon layer at a rate of about 200 Å/min or more, such as 400 Å/min.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the layers described above by including boron-containing or phosphorus-containing compounds in the reaction mixture. Suitable boron and phosphorus compounds generally comprise substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus hydrogen ratios will include hydrogen used as a carrier gas for dopants.

Dopants will generally be provided as dilute gas mixtures in an inert gas. For example, dopants may be provided at molar or volume concentrations of about 0.5% in a carrier gas. If a dopant is provided at a volume concentration of 0.5% in a carrier gas flowing at 1.0 sccm/L, the resultant dopant flow rate will be 0.005 sccm/L. Dopants may be provided to a reaction chamber at flow rates between about 0.0002 sccm/L and about 0.1 sccm/L depending on the degree of doping desired. In general, dopant concentration is maintained between about 10¹⁸ atoms/cm² and about 10²⁰ atoms/cm²_{.}

A p-type microcrystalline silicon layer may be deposited by providing a gas mixture of hydrogen gas and silane gas in ratio of hydrogen-to-silane of about 200:1 or greater, such as 1000:1 or less, for example between about 250:1 and about 800:1, and in a further example about 601:1 or about 401:1. Silane gas may be provided at a flow rate between about 0.1 sccm/L and about 0.8 sccm/L, such as between about 0.2 sccm/L and about 0.38 sccm/L. Hydrogen gas may be provided at a flow rate between about 60 sccm/L and about 500 sccm/L, such as about 143 sccm/L. TMB may be provided at a flow rate between about 0.0002 sccm/L and about 0.0016 sccm/L, such as about 0.00115 sccm/L. If TMB is provided in a 0.5% molar or volume concentration in a carrier gas, then the dopant/carrier gas mixture may be provided at a flow rate between about 0.04 sccm/L and about 0.32 sccm/L, such as about 0.23 sccm/L. Applying RF power between about 50 mW/cm² and about 700 mW/cm², such as between about 290 mW/cm² and about 440 mW/cm², at a chamber pressure between about 1 Torr and about 100 Torr, preferably between about 3 Torr and about 20 Torr, more preferably between 4 Torr and about 12 Torr, such as about 7 Torr or about 9 Torr, will deposit a p-type microcrystalline layer having crystalline fraction between about 20 percent and about 80 percent, preferably between 50 percent and about 70 percent for a microcrystalline layer, at about 10 Å/min or more, such as about 143 Å/min or more.

A p-type amorphous silicon layer may be deposited by providing a gas mixture of hydrogen gas to silane gas in a ratio of about 20:1 or less. Silane gas may be provided at a flow rate between about 1 sccm/L and about 10 sccm/L. Hydrogen gas may be provided at a flow rate between about 5 sccm/L and 60 sccm/L. Trimethylboron may be provided at a flow rate between about 0.005 sccm/L and about 0.05 sccm/L. If trimethylboron is provided in a 0.5% molar or volume concentration in a carrier gas, then the dopant/carrier gas mixture may be provided at a flow rate between about 1 sccm/L and about 10 sccm/L. Applying RF power between about 15 mWatts/cm² and about 200 mWatts/cm² at a chamber pressure between about 0.1 Torr and 20 Torr, preferably between about 1 Torr and about 4 Torr, will deposit a p-type amorphous silicon layer at about 100 Å/min or more.

An n-type microcrystalline silicon layer may be deposited by providing a gas mixture of hydrogen gas to silane gas in a ratio of about 100:1 or more, such as about 500:1 or less, such as between about 150:1 and about 400:1, for example about 304:1 or about 203:1. Silane gas may be provided at a flow rate between about 0.1 sccm/L and about 0.8 sccm/L, such as between about 0.32 sccm/L and about 0.45 sccm/L, for example about 0.35 sccm/L. Hydrogen gas may be provided at a flow rate between about 30 sccm/L and about 250 sccm/L, such as between about 68 sccm/L and about 143 sccm/L, for example about 71.43 sccm/L. Phosphine may be provided at a flow rate between about 0.0005 sccm/L and about 0.006 sccm/L, such as between about 0.0025 sccm/L and about 0.015 sccm/L, for example about 0.005 sccm/L. In other words, if phosphine is provided in a 0.5% molar or volume concentration in a carrier gas, then the dopant/carrier gas may be provided at a flow rate between about 0.1 sccm/L and about 5 sccm/L, such as between about 0.5 sccm/L and about 3 sccm/L, for example between about 0.9 sccm/L and about 1.088 sccm/L. Applying RF power between about 100 mW/cm² and about 900 mW/cm², such as about 370 mW/cm², at a chamber pressure of between about 1 Torr and about 100 Torr, preferably between about 3 Torr and about 20 Torr, more preferably between 4 Torr and about 12 Torr, for example about 6 Torr or about 9 Torr, will deposit an n-type microcrystalline silicon layer having a crystalline fraction between about 20 percent and about 80 percent, preferably between 50 percent and about 70 percent, at a rate of about 50 Å/min or more, such as about 150 Å/min or more.

An n-type amorphous silicon layer may be deposited by providing a gas mixture of hydrogen gas to silane gas in a ratio of about 20:1 or less, such as about 5:5:1 or 7.8:1. Silane gas may be provided at a flow rate between about 0.1 sccm/L and about 10 sccm/L, such as between about 1 sccm/L and about 10 sccm/L, between about 0.1 sccm/L and 5 sccm/L, or between about 0.5 sccm/L and about 3 sccm/L, for example about 1.42 sccm/L or 5.5 sccm/L. Hydrogen gas may be provided at a flow rate between about 1 sccm/L and about 40 sccm/L, such as between about 4 sccm/L and about 40 sccm/L, or between about 1 sccm/L and about 10 sccm/L, for example about 6.42 sccm/L or 27 sccm/L. Phosphine may be provided at a flow rate between about 0.0005 sccm/L and about 0.075 sccm/L, such as between about 0.0005 sccm/L and about 0.0015 sccm/L or between about 0.015 sccm/L and about 0.03 sccm/L, for example about 0.0095 sccm/L or 0.023 sccm/L. If phosphine is provided in a 0.5% molar or volume concentration in a carrier gas, then the dopant/carrier gas mixture may be provided at a flow rate between about 0.1 sccm/L and about 15 sccm/L, such as between about 0.1 sccm/L and about 3 sccm/L, between about 2 sccm/L and about 15 sccm/L, or between about 3 sccm/L and about 6 sccm/L, for example about 1.9 sccm/L or about 4.71 sccm/L. Applying RF power between about 25 mW/cm² and about 250 mW/cm², such as about 60 mW/cm² or about 80 mW/cm², at a chamber pressure between about 0.1 Torr and about 20 Torr, preferably between about 0.5 Torr and about 4 Torr, such as about 1.5 Torr, will deposit an n-type amorphous silicon layer at a rate of about 100 Å/min or more, such as about 200 Å/min or more, such as about 300 Å/min or about 600 Å/min.

In some embodiments, layers may be heavily doped or degenerately doped by supplying dopant compounds at high rates, for example at rates in the upper part of the recipes described above. It is thought that degenerate doping improves charge collection by providing low-resistance contact junctions. Degenerate doping is also thought to improve conductivity of some layers, such as amorphous layers.

In some embodiments, alloys of silicon with other elements such as oxygen, carbon, nitrogen, and germanium may be useful. These other elements may be added to silicon films by supplementing the reactant gas mixture with sources of each. For example, carbon may be added to the film by adding a carbon source such as methane (CH₄) to the gas mixture. In general, most C₁-C₄ hydrocarbons may be used as carbon sources. Alternately, organosilicon compounds known to the art, such as organosilanes, organosiloxanes, organosilanols, and the like may serve as both silicon and carbon sources. Germanium compounds such as germanes and organogermanes, along with compounds comprising silicon and germanium, such as silylgermanes or germylsilanes, may serve as germanium sources. Oxygen gas (O₂) may serve as an oxygen source. Other oxygen sources include, but are not limited to, oxides of nitrogen (nitrous oxide - N₂O, nitric oxide - NO, dinitrogen trioxide - N₂O₃, nitrogen dioxide - NO₂, dinitrogen tetroxide - N₂O₄, dinitrogen pentoxide - N₂O₅, and nitrogen trioxide - NO₃), hydrogen peroxide (H₂O₂), carbon monoxide or dioxide (CO or CO₂), ozone (O₃), oxygen atoms, oxygen radicals, and alcohols (ROH, where R is any organic or hetero-organic radical group). Nitrogen sources may include nitrogen gas (N₂), ammonia (NH₃), hydrazine (N₂H₂), amines (RₓNR'₃₋ₓ, where x is 0 to 3, and each R and R' is independently any organic or hetero-organic radical group), amides ((RCO)ₓNR'₃₋ₓ, where x is 0 to 3 and each R and R' is independently any organic or hetero-organic radical group), imides (RCONCOR', where each R and R' is independently any organic or hetero-organic radical group), enamines (R₁R₂C=C₃NR₄R₅, where each R₁-R₅ is independently any organic or hetero-organic radical group), and nitrogen atoms and radicals.

It should be noted that in many embodiments pre-clean processes may be used to prepare substrates and/or reaction chambers for deposition of the above layers. A hydrogen or argon plasma pre-treat process may be performed to remove contaminants from substrates and/or chamber walls by supplying hydrogen gas or argon gas to the processing chamber between about 10 sccm/L and about 45 sccm/L, such as between about 15 sccm/L and about 40 sccm/L, for example about 20 sccm/L and about 36 sccm/L. In one example, the hydrogen gas may be supplied at about 21 sccm/L or the argon gas may be supplied at about 36 sccm/L. The treatment is accomplished by applying RF power between about 10 mW/cm² and about 250 mW/cm², such as between about 25 mW/cm² and about 250 mW/cm², for example about 60 mW/cm² or about 80 mW/cm² for hydrogen treatment and about 25 mW/cm² for argon treatment. In many embodiments it may be advantageous to perform an argon plasma pre-treatment process prior to depositing a p-type amorphous silicon layer, and a hydrogen plasma pre-treatment process prior to depositing other types of layers.

### SOLAR CELL EMBODIMENTS

Embodiments of the present invention provide methods and apparatuses for forming thin-film and crystalline solar cells having improved efficiency. In the embodiments that follow, deposition of the various layers is accomplished according to the recipes described above. The layers described in the embodiments that follow may be formed to any convenient thickness, depending on the needs of the different embodiments. N-type doped layers will generally have a thickness between about 100 Å and about 1,000 Å, such as between about 200 Å and about 500 Å, for example about 300 Å. P-type doped layers will generally have a thickness between about 50 Å and about 300 Å, such as between about 150 Å and about 250 Å, for example about 200 Å. Conductive layers will generally have a thickness between about 500 Å and about 20,000 Å, such as between about 5,000 Å and about 11,000 Å, for example about 8,000 Å. Intrinsic layers will generally have a thickness between about 1,000 Å and about 10,000 Å, such as between about 2,000 Å and 4,000 Å, for example about 3,000 Å. PIB layers will generally have a thickness between about 50 Å and about 500 Å, such as between about 100 Å and about 300 Å, for example about 200 Å.

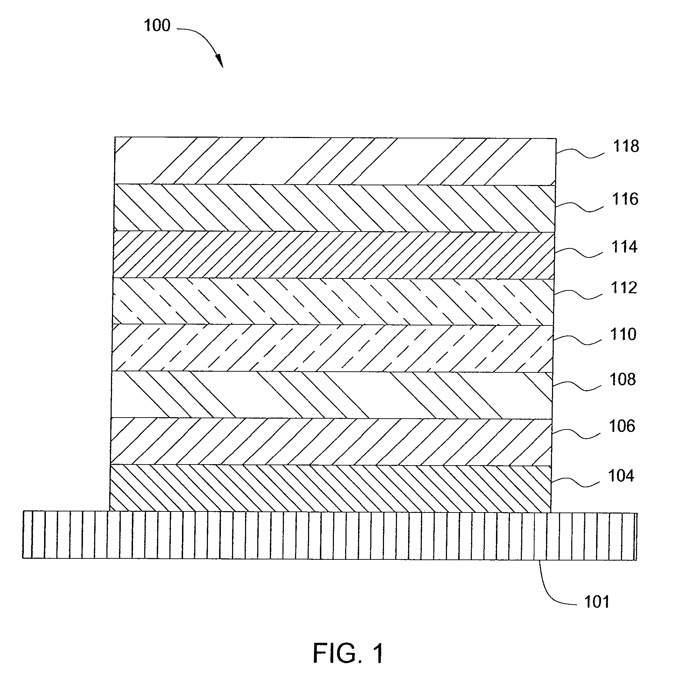

Figure 1 is a schematic side-view of a single-junction thin-film solar cell 100 according to one embodiment of the invention. Solar cell 100 comprises a substrate 101, such as a glass substrate, polymer substrate, metal substrate, or other suitable substrate, with thin films formed thereover. A conductive layer 104 is formed on the substrate 101. The conductive layer 104 is preferably substantially transparent, such as a transparent conductive oxide (TCO) layer. In all embodiments described herein, a TCO layer may comprise tin oxide, zinc oxide, indium tin oxide, cadmium stannate, combinations thereof, or other suitable materials, and may also include additional dopants and components. For example, zinc oxide may further include dopants, such as aluminum, gallium, boron, and other suitable dopants. Zinc oxide preferably comprises 5 atomic % or less of dopants, and more preferably comprises 2.5 atomic % or less aluminum. In certain instances, the substrate 101 may be provided by the glass manufacturers with the conductive layer 104 already formed. To improve light absorption by reducing light reflection, the substrate and/or one or more of thin films formed thereover may be optionally textured by wet, plasma, ion, and/or mechanical processes. For example, in some embodiments, the conductive layer 104 is textured and the subsequent thin films deposited thereover will generally follow the topography of the surface below.

An degeneratively-doped p-type amorphous silicon layer 106 is formed over the conductive layer 104. A p-type amorphous silicon alloy layer 108 is formed over the degeneratively-doped p-type amorphous silicon layer 106. A PIB layer 110 is formed over the p-type amorphous silicon alloy layer 108. An intrinsic amorphous silicon layer 112 is formed over the PIB layer 110. An n-type amorphous silicon layer 114 is formed over the intrinsic amorphous silicon layer 112.

Prior to forming a top contact layer 118 of the solar cell, an n-type crystalline silicon alloy layer 116 is formed over the n-type amorphous silicon layer 114. The n-type crystalline silicon alloy layer 116 may be microcrystalline, nanocrystalline, or polycrystalline, and may be formed using the recipes described elsewhere herein. The n-type crystalline silicon alloy layer 116 may contain carbon, oxygen, nitrogen, or any combination thereof. It may be deposited as a single homogeneous layer, a single layer with one or more graduated characteristics, or as multiple layers. The graduated characteristics may include crystallinity, dopant concentration, alloy material concentration, or other characteristics such as dielectric constant, refractive index, conductivity, or bandgap. The n-type crystalline silicon alloy layer may be an n-type silicon carbide layer, an n-type silicon oxide layer, an n-type silicon nitride layer, and n-type silicon oxynitride layer, an n-type silicon oxycarbide layer, or an n-type silicon oxycarbonitride layer.

The quantities of secondary components in the n-type crystalline silicon alloy layer 116 may deviate from stoichiometric ratios to some degree. For example, an n-type silicon carbide layer may have between about 1 atomic % and about 50 atomic % carbon. An n-type silicon nitride layer may likewise have between about 1 atomic % and about 50 atomic % nitrogen. An n-type silicon oxide layer may have between about 1 atomic % and about 50 atomic % oxygen. In an alloy comprising more than one secondary component, the content of secondary components may be between about 1 atomic % and about 50 atomic %, with silicon content between 50 atomic % and 99 atomic %. The quantity of secondary components may be adjusted by adjusting the ratios of precursor gases in the processing chamber. The ratios may be adjusted in steps to form layered structures, or continuously to form graduated single layers.

Methane (CH₄) may be added to the reaction mixture for an n-type microcrystalline silicon layer to form an n-type microcrystalline silicon carbide layer. In one embodiment, the ratio of methane gas flow rate to silane flow rate is between about 0 and about 0.5, such as between about 0.20 and about 0.35, for example about 0.25. The ratio of methane gas to silane in the feed may be varied to adjust the amount of carbon in the deposited film. The film may be deposited in a number of layers, each having different carbon content, or the carbon content may be continuously adjusted through the deposited layer. Moreover, the carbon and dopant content may be adjusted and graduated simultaneously within the layer. Depositing the film as a number of layers has advantages in that multiple layers having different refractive indices may operate as a Bragg reflector, significantly enhancing the reflectivity of the layer in the mid- and long-wavelength range.

The n-type crystalline silicon alloy layer 116 formed adjacent the top contact layer 118 provides several advantages to the solar cell embodiment. The layer is highly conductive, with adjustable bandgap and refractive index. Microcrystalline silicon carbide, for example, develops crystalline fraction above 60%, bandgap width above 2 electronvolts (eV), and conductivity greater than 0.1 siemens per centimeter (S/cm). Moreover, it can be deposited at rates of 150-200 Å/min with thickness variation less than 10%. The bandgap and refractive index can be adjusted by varying the ratio of methane to silane in the reaction mixture. The adjustable refractive index allows formation of a reflective layer that is highly conductive with wide bandgap, resulting in improved current and fill factor.

The top contact layer 118 is generally a conductive layer, which may be a metal layer, such as a layer comprising one or more materials selected from the group consisting of Al, Ag, Ti, Cr, Au, Cu, Pt, alloys thereof, or combinations thereof. Alternately, the top contact layer 118 may be a transparent conductive oxide (TCO) layer formed over such a metal layer, such as a metal/TCO stack layer.

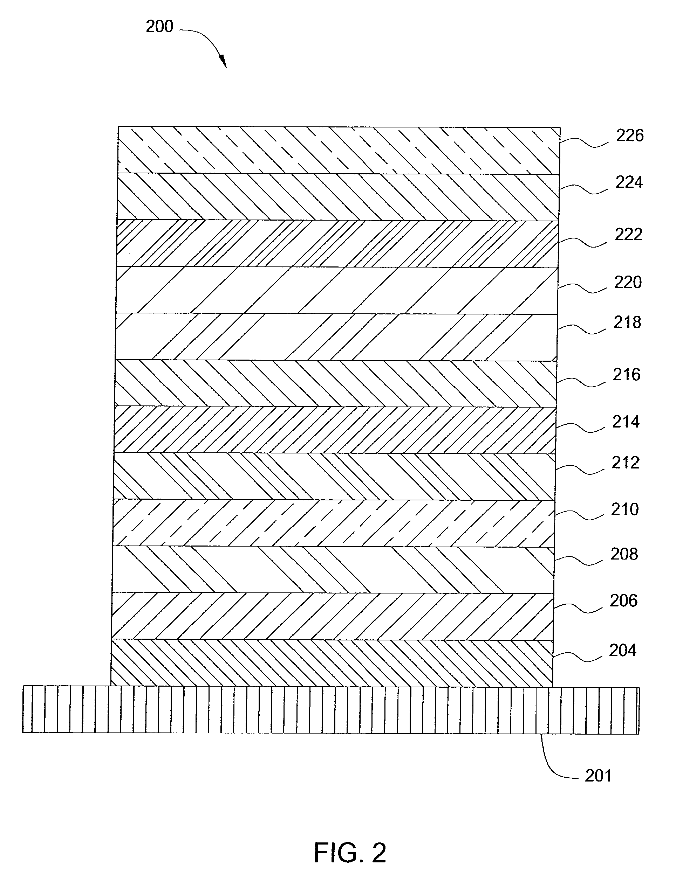

Figure 2 is a schematic side-view of a tandem-junction thin-film solar cell 200 according to another embodiment of the invention. A substrate 201 similar to the substrate 101 of Figure 1 has a conductive layer 204 similar to the conductive layer 104 of Figure 1 formed thereon. Degeneratively- and normally-doped p-type amorphous silicon layers 206 and 208, similar to corresponding layers 106 and 108 of Figure 1, are formed next, followed by a first PIB layer 210. An intrinsic amorphous silicon layer 212 is formed, followed by an n-type amorphous silicon layer 214. A first n-type crystalline silicon alloy layer 216 is formed on the n-type amorphous silicon layer 214 to complete the first cell. The n-type crystalline silicon alloy layer 216 forms the n-layer of the first p-i-n junction of the tandem-junction thin-film solar cell 200.

The embodiment of Figure 2 features two p-i-n junctions for increased charge generation, so a p-type crystalline silicon alloy layer 218 is formed over the n-type crystalline silicon alloy layer 216 to start the second cell. Following a PIB layer 220 and an intrinsic crystalline silicon layer 222, a second n-type crystalline silicon alloy layer 224 is formed prior to forming a contact layer 226, similar to the structure of the solar cell 100 of Figure 1. For most embodiments featuring crystalline layers, a microcrystalline morphology is preferred, but nanocrystalline, monocrystalline, and polycrystalline layers may be used as well.

In the embodiment of Figure 2, the n-type crystalline silicon alloy layer serves two purposes, as a reflective back contact layer and as a junction layer. Inclusion of the alloy layer 212 as a junction layer boosts absorption of long wavelength light by the solar cell and improves short-circuit current, resulting in improved quantum and conversion efficiency.

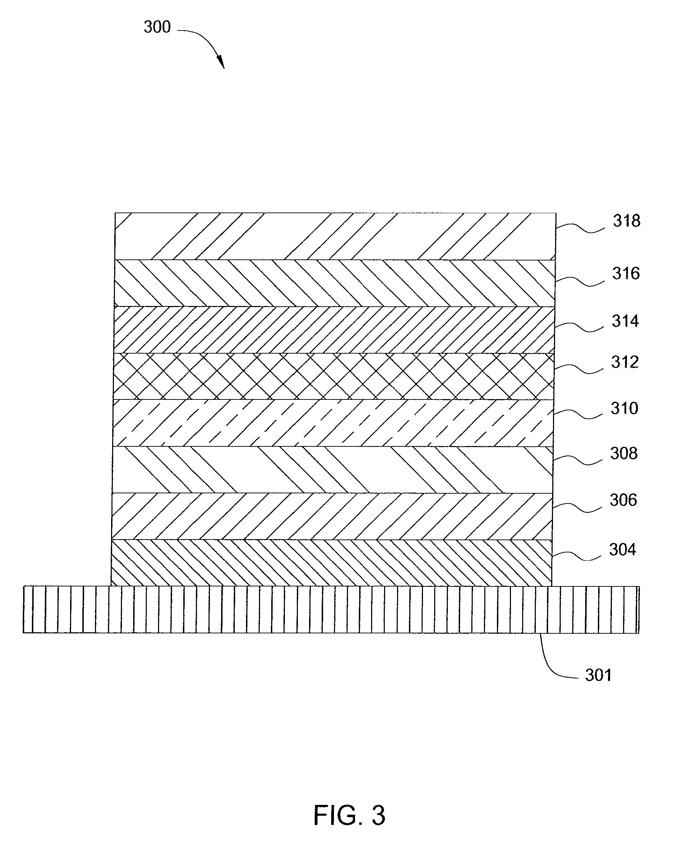

Figure 3 is a schematic side-view of a single-junction thin-film solar cell 300 according to another embodiment of the invention. The embodiment of Figure 3 differs from that of Figure 1 by inclusion of a p-type crystalline silicon alloy layer between the p-type amorphous silicon layer and the top TCO layer, instead of a degeneratively doped layer such as layer 114 of Figure 1. The embodiment of Figure 3 thus comprises a substrate 301 on which a conductive layer 304, such as a TCO layer, is formed. As described above, a p-type crystalline silicon alloy layer 306 is formed over the conductive layer 304. The p-type crystalline silicon alloy layer 306 has improved bandgap due to lower doping, adjustable refractive index generally lower than that of a degeneratively doped layer, high conductivity, and resistance to oxygen attack by virtue of the included alloy components. A p-i-n junction is formed over the p-type crystalline silicon alloy layer 306 by forming a p-type amorphous silicon layer 308, a PIB layer 310, an intrinsic amorphous silicon layer 312, and an n-type amorphous silicon layer 314. The solar cell 300 of Figure 3 is completed, similar to the foregoing embodiments, with an n-type crystalline silicon alloy layer 316 and a conductive layer 318, which may be a metal or metal/TCO stack, similar to the conductive layer 118 of Figure 1.

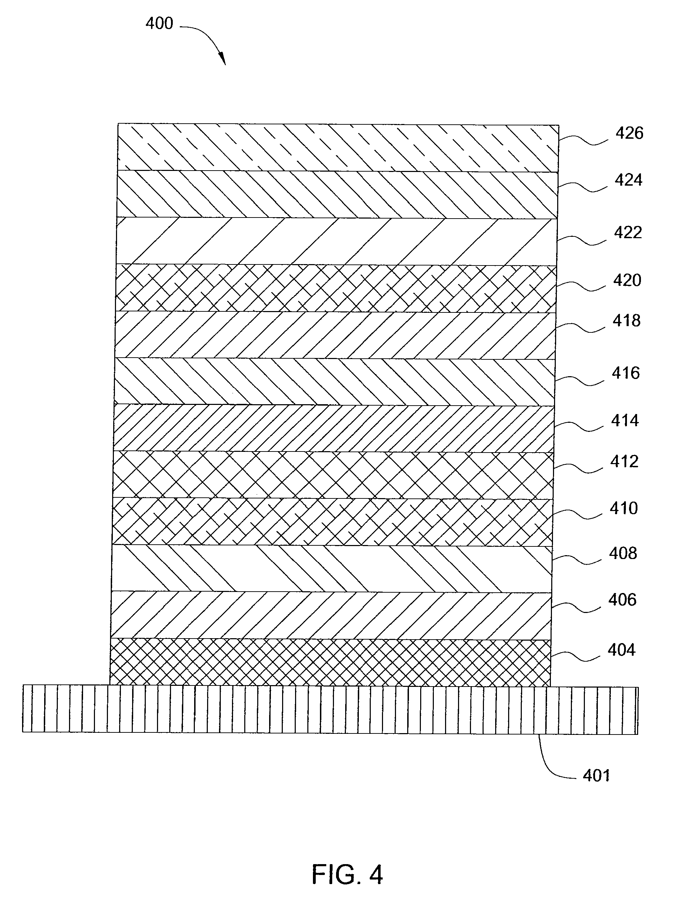

Figure 4 is a schematic side-view of a tandem-junction thin-film solar cell 400 according to another embodiment of the invention. The embodiment of Figure 4 differs from that of Figure 2 by inclusion of a first p-type crystalline silicon alloy layer between the conductive layer 204 and the p-type amorphous silicon alloy layer 208, replacing the degenerative-doped p-type amorphous silicon layer 206. The embodiment of Figure 4 thus comprises a substrate 401 similar to the substrates of the foregoing embodiments, with a conductive layer 404, a first p-type crystalline silicon alloy layer 406, a p-type amorphous silicon alloy layer 408, and a first PIB layer 410 formed thereover. The first p-type crystalline silicon layer 406 replaces the degenerative-doped p-type amorphous silicon layer 206 of Figure 2. The first p-i-n junction of the tandem-junction thin-film solar cell 400 is completed by forming an intrinsic amorphous silicon layer 412, an n-type amorphous silicon layer 414, and a first n-type crystalline silicon alloy layer 416 over the PIB layer 410.

A second p-i-n junction is then formed over the first p-i-n junction, with a second p-type crystalline silicon alloy layer 418, a second PIB layer 420, an intrinsic crystalline silicon layer 422, and a second n-type crystalline silicon alloy layer 424 formed over the first n-type crystalline silicon alloy layer. The second p-i-n junction is similar to the second p-i-n junction of the solar cell 200 of Figure 2. The solar cell 400 is completed by adding a top contact layer 426 over the second n-type crystalline silicon alloy layer 424. As described above, the top contact layer 426 may be a metal layer or a metal/TCO stack layer.

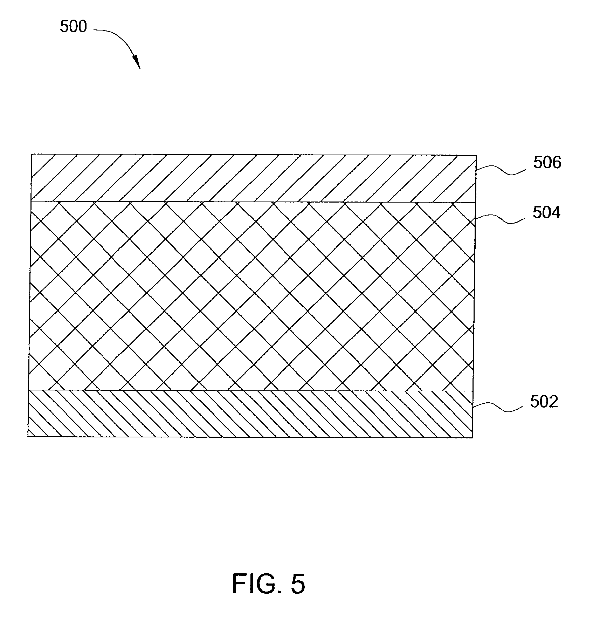

Figure 5 is a schematic side-view of a crystalline solar cell 500 according to another embodiment of the invention. The embodiment of Figure 5 comprises a semiconductor substrate 502, on which a crystalline silicon alloy layer 504 is formed. The crystalline silicon alloy layer 504 may be formed according to any of the embodiments and recipes disclosed herein, and may be a single alloy layer or a combination or multi-layer stack. The crystalline silicon alloy layer 504 has adjustable low refractive index, as discussed above, and may be structured to enhance reflectivity, allowing the crystalline silicon alloy layer 504 to serve as a back reflector layer for the crystalline solar cell junction 506 formed thereon. In the embodiment of Figure 5, the crystalline silicon alloy layer 504 may be formed to any convenient thickness, depending on the structure of the layer. A single layer embodiment may have a thickness between about 500 Å and about 5,000 Å, such as between about 1,000 Å and about 2,000 Å, for example about 1,500 Å. A multi-layer structure may feature a plurality of layers, each having a thickness between about 100 Å and about 1,000 Å.

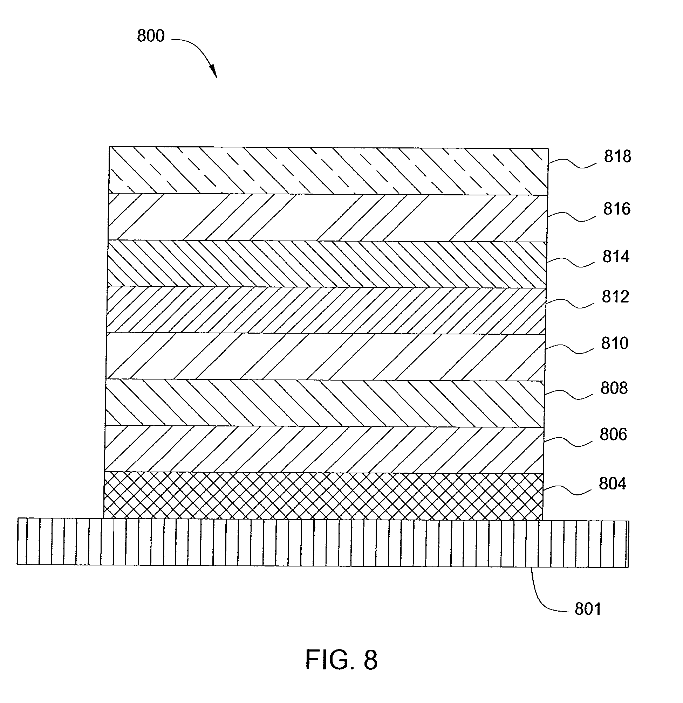

Other embodiments of the invention feature thin-film solar cells wherein all layers are crystalline layers. Figure 8 is a schematic side-view of a tandem-junction thin-film solar cell according to another embodiment. The embodiment of Figure 8 features two simple p-i-n junctions formed from crystalline layers. The embodiment of Figure 8 thus comprises a substrate 801 on which a conductive layer 804 is formed, similar to the foregoing embodiments. A first p-i-n junction formed over the conductive layer 804 comprises a first p-type crystalline silicon alloy layer 806, a first intrinsic crystalline silicon alloy layer 808 formed over the p-type crystalline silicon alloy layer, and a first n-type crystalline silicon alloy layer 810 formed over the first intrinsic crystalline silicon alloy layer 808. A second p-i-n junction is formed over the first p-i-n junction, and comprises a second p-type crystalline silicon alloy layer 812, a second intrinsic crystalline silicon alloy layer 814 over the second p-type crystalline silicon alloy layer 812, and a second n-type crystalline silicon alloy layer 816 over the second intrinsic crystalline silicon alloy layer 814. A top contact layer 818 is formed over the second p-i-n junction.

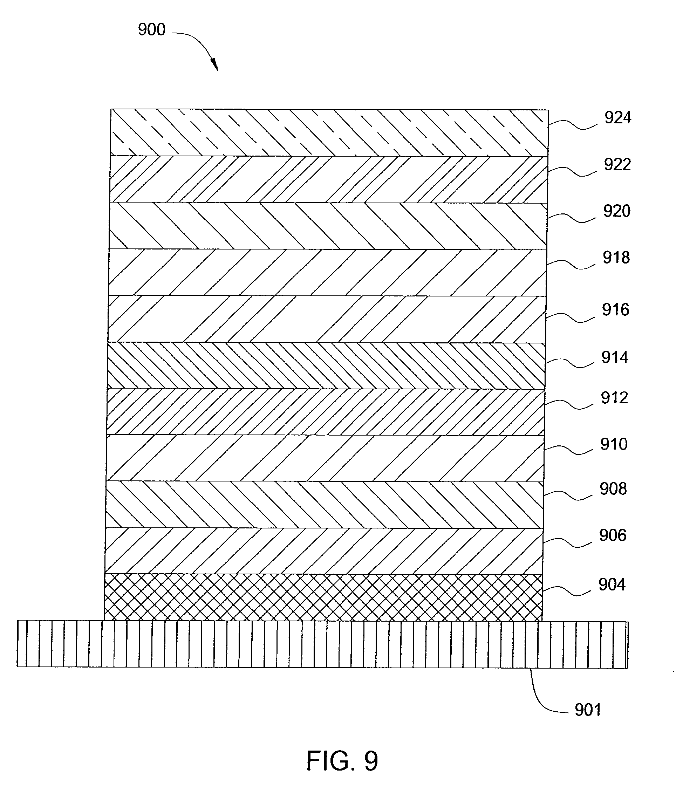

Figure 9 is a schematic side-view of a triple-junction thin-film solar cell according to another embodiment of the invention. The embodiment of Figure 9 features three p-i-n junctions formed from crystalline layers. The embodiment of Figure 9 thus comprises a substrate 901 and conductive layer 904, similar to the foregoing embodiments, with a first p-i-n junction formed thereover. The first p-i-n junction comprises first p-type, intrinsic, and n-type crystalline silicon alloy layers, 906, 908, and 910, respectively. A second p-i-n junction comprising second p-type, intrinsic, and n-type crystalline silicon alloy layers 912, 914, and 916, respectively, is formed over the first p-i-n junction. A third p-i-n junction comprising third p-type, intrinsic, and n-type crystalline silicon alloy layers 918, 920, and 922, respectively, is formed over the second p-i-n junction. A top contact layer 924 is formed over the third p-i-n junction.

The tandem and triple junction embodiments of figure 8 and 9 contemplate variations available in the type of alloy materials included in the various layers. For example, in one embodiment, the layers of one p-i-n junction may use carbon as an alloy material, while the layers of another p-i-n junction use germanium. For example, in the embodiment of Figure 8, the crystalline alloy layers 806, 808, and 810 may comprise an alloy of silicon and carbon, while the layers 812, 814, and 816 may comprise an alloy of silicon and germanium. Likewise, in the embodiment of Figure 9, the layers 906, 908, 910, 912, 914, and 916 may comprise alloys of silicon and carbon, while the layers 918, 920, and 922 comprise layers of silicon and germanium. Finally, the embodiments of figures 8 and 9 also contemplate variations wherein one of the intrinsic layers is not an alloy layer. For example, in an alternate embodiment of Figure 8, the layer 808 is an intrinsic crystalline silicon layer, not an alloy layer. Likewise, in an alternate embodiment of Figure 9, the intrinsic layer 914 is an intrinsic crystalline silicon layer, not an alloy layer. Such variations broaden the absorption characteristics of the cell and improve its charge separation capabilities.

### EXAMPLES

Table 1 contains examples of various n-type silicon carbide layers of varying crystallinity. These examples were deposited on substrates measuring 72 cm x 60 cm, for an area of 4,320 cm², with hydrogen gas flow rate of 50,000 sccm and RF power of 3 kW.

**Table 1**

| **Layer Type** | **CH₄ (sccm)** | **SiH₄ (sccm)** | **Pressure (Torr)** | **H₂/SiH₄ Flow Ratio** | **D/R (Ǻ/min)** | **Conductivity (S/cm)** | **Optical Bandgap (eV)** | **Crystalline Fraction (%)** | **Uniformity (%)** |
|---|---|---|---|---|---|---|---|---|---|
| amorphous | 20 | 100 | 4 | 503 | 96 | 3.86x10⁻⁵ | 2.16 | 0 | 9.1 |
| crystalline | 20 | 100 | 6 | 503 | 154 | 0.0393 | 2.10 | 51 | 5.4 |
| crystalline | 20 | 100 | 7 | 503 | 177 | 0.302 | 2.10 | 55 | 5.8 |
| crystalline | 20 | 100 | 8 | 503 | 186 | 0.994 | 2.03 | 60 | 5.1 |
| crystalline | 20 | 100 | 9 | 503 | 185 | 2.12 | 2.02 | 60 | 8.2 |
| crystalline | 20 | 100 | 10 | 503 | 190 | 3.18 | 1.98 | 61 | 9.2 |
| crystalline | 20 | 100 | 12 | 503 | 163 | 4.08 | 1.98 | 60 | 13.7 |
| crystalline | 20 | 100 | 9 | 503 | 185 | 2.12 | 2.02 | 60 | 8.2 |
| crystalline | 25 | 100 | 9 | 503 | 191 | 0.775 | 2.01 | 56 | 8.0 |
| crystalline | 30 | 100 | 9 | 503 | 174 | 0.085 | 2.09 | 41 | 5.1 |
| amorphous | 35 | 100 | 9 | 503 | 156 | --- | 2.11 | 0 | 7.0 |
| crystalline | 20 | 100 | 9 | 503 | 185 | 2.12 | 2.02 | 60 | 8.2 |
| crystalline | 20 | 80 | 9 | 629 | 166 | 1.83 | 2.04 | 62 | 7.5 |
| crystalline | 20 | 67 | 9 | 751 | 131 | 1.88 | 2.03 | 62 | 5.2 |
| crystalline | 20 | 57 | 9 | 883 | 56 | 3.06 | --- | 63 | 2.6 |

Table 1 demonstrates that crystalline silicon carbide can be deposited using a highpressure plasma deposition process to yield a layer having high conductivity, wide bandgap, and good uniformity.

A single junction solar cell constructed with a 280 Å microcrystalline silicon carbide n-layer exhibited short current (Jsc) of 13.6 milliAmps per square centimeter (mA/cm²) and fill factor (FF) of 73.9%, with quantum efficiency (QE) of 13.4% and conversion efficiency (CE) of 9.4%. By comparison, a similar cell using microcrystalline silicon exhibited J_{SC} of 13.2 mA/cm², FF of 73.6%, QE of 13.0% and CE of 9.0%. By further comparison, a similar cell using a 280 Å amorphous silicon n-layer, 80 Å of which is degeneratively doped, exhibited J_{SC} of 13.1 mA, FF of 74.7%, QE of 12.7, and CE of 9.0.

A tandem junction solar cell was constructed having a bottom cell n-layer comprising 270 Å of microcrystalline silicon carbide, and a top cell n-layer comprising 100 Å of n-type amorphous silicon and 250 Å of n-type microcrystalline silicon carbide. The bottom cell exhibited J_{SC} of 9.69 mA/cm² and QE of 58% with 700 nm light. The top cell exhibited J_{SC} of 10.82 mA/cm² and QE of 78% with 500 nm light. Another tandem solar cell was constructed having a bottom cell n-layer comprising 270 Å of n-type microcrystalline silicon carbide, and a top cell n-layer comprising 50 Å of n-type amorphous silicon and 250 Å of n-type microcrystalline silicon carbide. The bottom cell exhibited J_{SC} of 9.62 mA/cm² and QE of 58% with 700 nm light. The top cell exhibited J_{SC} of 10.86 mA and QE of 78% with 500 nm light. By comparison, a tandem junction solar cell was constructed having a bottom cell n-layer comprising 270 Å of of n-type microcrystalline silicon, and a top cell n-layer comprising 200 Å of n-type amorphous silicon and 90 Å of degeneratively doped (n-type) amorphous silicon. The bottom cell exhibited J_{SC} of 9.00 mA/cm² and QE of 53% with 700 nm light. The top cell exhibited J_{SC} of 10.69 mA/cm² and QE of 56% with 500 nm light. Use of silicon carbide thus improved absorption in both cells, most notably in the bottom cell.

### APPARATUS

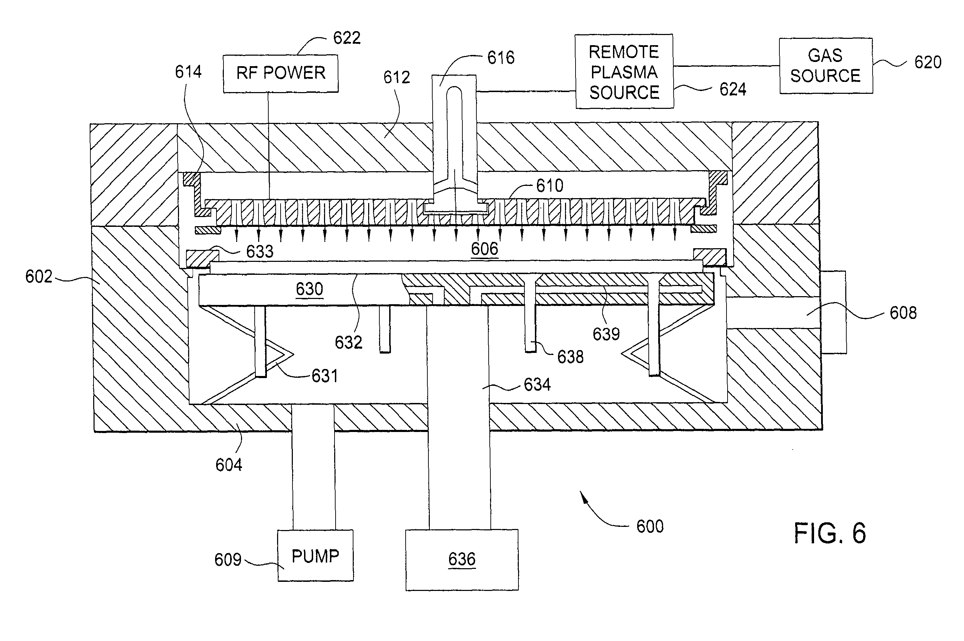

Figure 6 is a schematic cross-section view of one embodiment of a plasma enhanced chemical vapor deposition (PECVD) chamber 600 in which one or more films of a thin-film solar cell, such as the solar cells of figures 1-4 may be deposited. One suitable plasma enhanced chemical vapor deposition chamber is available from Applied Materials, Inc., located in Santa Clara, CA. It is contemplated that other deposition chambers, including those from other manufacturers, may be utilized to practice the present invention.

The chamber 600 generally includes walls 602, a bottom 604, and a showerhead 610, and substrate support 630 which define a process volume 606. The process volume is accessed through a valve 608 such that the substrate, such as substrate 100, may be transferred in and out of the chamber 600. The substrate support 630 includes a substrate receiving surface 632 for supporting a substrate and stem 634 coupled to a lift system 636 to raise and lower the substrate support 630. A shadow ring 633 may be optionally placed over periphery of the substrate 100. Lift pins 638 are moveably disposed through the substrate support 630 to move a substrate to and from the substrate receiving surface 632. The substrate support 630 may also include heating and/or cooling elements 639 to maintain the substrate support 630 at a desired temperature. The substrate support 630 may also include grounding straps 631 to provide RF grounding at the periphery of the substrate support 630.

The showerhead 610 is coupled to a backing plate 612 at its periphery by a suspension 614. The showerhead 610 may also be coupled to the backing plate by one or more center supports 616 to help prevent sag and/or control the straightness/curvature of the showerhead 610. A gas source 620 is coupled to the backing plate 612 to provide gas through the backing plate 612 and through the showerhead 610 to the substrate receiving surface 632. A vacuum pump 609 is coupled to the chamber 600 to control the process volume 606 at a desired pressure. An RF power source 622 is coupled to the backing plate 612 and/or to the showerhead 610 to provide a RF power to the showerhead 610 so that an electric field is created between the showerhead and the substrate support so that a plasma may be generated from the gases between the showerhead 610 and the substrate support 630. Various RF frequencies may be used, such as a frequency between about 0.3 MHz and about 200 MHz. In one embodiment the RF power source is provided at a frequency of 13.56 MHz.

A remote plasma source 624, such as an inductively coupled remote plasma source, may also be coupled between the gas source and the backing plate. Between processing substrates, a cleaning gas may be provided to the remote plasma source 624 so that a remote plasma is generated and provided to clean chamber components. The cleaning gas may be further excited by the RF power source 622 provided to the showerhead. Suitable cleaning gases include but are not limited to NF₃, F₂, and SF₆.

The deposition methods for one or more layers, such as one or more of the layers of figures 1-4, may include the following deposition parameters in the process chamber of Figure 6 or other suitable chamber. A substrate having a surface area of 10,000 cm² or more, preferably 40,000 cm² or more, and more preferably 55,000 cm² or more is provided to the chamber. It is understood that after processing the substrate may be cut to form smaller solar cells.

In one embodiment, the heating and/or cooling elements 639 may be set to provide a substrate support temperature during deposition of about 400°C or less, preferably between about 100°C and about 400°C, more preferably between about 150°C and about 300°C, such as about 200°C.

The spacing during deposition between the top surface of a substrate disposed on the substrate receiving surface 632 and the showerhead 610 may be between 400 mil and about 1,200 mil, preferably between 400 mil and about 800 mil.

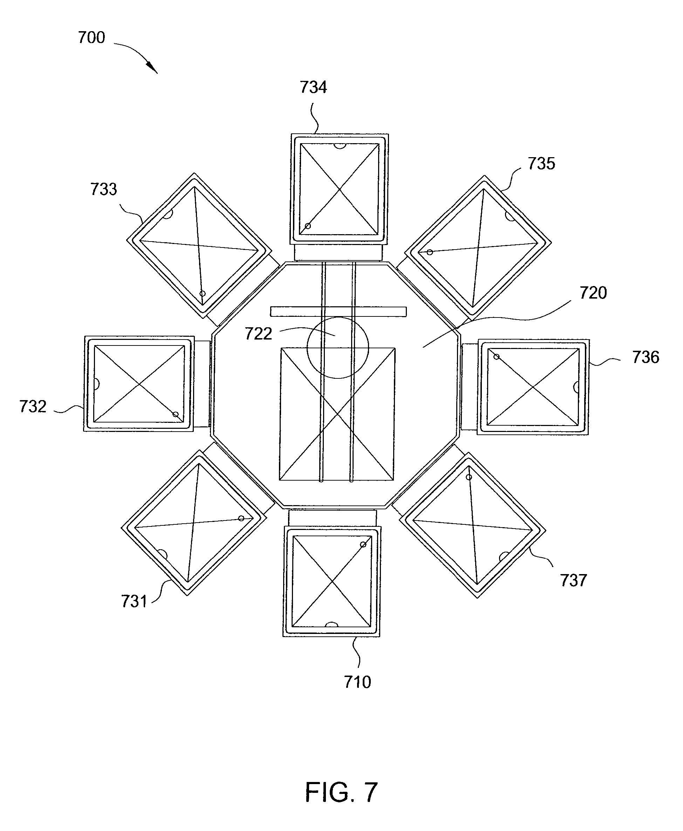

Figure 7 is a top schematic view of one embodiment of a process system 700 having a plurality of process chambers 731-737, such as PECVD chamber 600 of Figure 6 or other suitable chambers capable of depositing silicon films. The process system 700 includes a transfer chamber 720 coupled to a load lock chamber 710 and the process chambers 731-737. The load lock chamber 710 allows substrates to be transferred between the ambient environment outside the system and vacuum environment within the transfer chamber 720 and process chambers 731-737. The load lock chamber 710 includes one or more evacuatable regions holding one or more substrate. The evacuatable regions are pumped down during input of substrates into the system 700 and are vented during output of the substrates from the system 700. The transfer chamber 720 has at least one vacuum robot 722 disposed therein that is adapted to transfer substrates between the load lock chamber 710 and the process chambers 731-737. Seven process chambers are shown in Figure 7; however, the system may have any suitable number of process chambers.

In certain embodiments of the invention, one system 700 is configured to deposit the first p-i-n junction of a multi-junction solar cell, such as layers 204-210 of Figure 2 or layers 404-410 of Figure 4. One of the process chambers 731-737 is configured to deposit the p-type layer(s) of the first p-i-n junction while the remaining process chambers 731-737 are each configured to deposit both the intrinsic type layer(s) and the n-type layer(s). The intrinsic type layer(s) and the n-type layer(s) of the first p-i-n junction may be deposited in the same chamber without any passivation process in between the deposition steps. Thus, a substrate enters the system through the load lock chamber 710, is transferred by the vacuum robot into the dedicated process chamber configured to deposit the p-type layer(s), is transferred by the vacuum robot into one of the remaining process chamber configured to deposit both the intrinsic type layer(s) and the n-type layer(s), and is transferred by the vacuum robot back to the load lock chamber 710. In certain embodiments, the time to process a substrate with the process chamber to form the p-type layer(s) is approximately 4 or more times faster, preferably 6 or more times faster, than the time to form the intrinsic type layer(s) and the n-type layer(s) in a single chamber. Therefore, in certain embodiments of the system to deposit the first p-i-n junction, the ratio of p-chambers to i/n-chambers is 1:4 or more, preferably 1:6 or more. The throughput of the system including the time to provide plasma cleaning of the process chambers may be about 10 substrates/hr or more, preferably 20 substrates/hr or more.

In certain embodiments of the invention, one system 700 is configured to deposit the second p-i-n junction of a multi-junction solar cell, such as layers 212-222 of Figure 2 or layers 412-422 of Figure 4. One of the process chambers 731-737 is configured to deposit the p-type layer(s) of the second p-i-n junction while the remaining process chambers 731-737 are each configured to deposit both the intrinsic type layer(s) and the n-type layer(s). The intrinsic type layer(s) and the n-type layer(s) of the second p-i-n junction may be deposited in the same chamber without any passivation process in between the deposition steps. In certain embodiments, the time to process a substrate with the process chamber to form the p-type layer(s) is approximately 4 or more times faster than the time to form the intrinsic type layer(s) and the n-type layer(s) in a single chamber. Therefore, in certain embodiments of the system to deposit the second p-i-n junction, the ratio of p-chambers to i/n-chambers is 1:4 or more, preferably 1:6 or more. The throughput of the system including the time to provide plasma cleaning of the process chambers may be about 3 substrates/hr or more, preferably 5 substrates/hr or more.

In certain embodiments, the throughput of the system 700 for depositing the second p-i-n junction comprising an intrinsic type amorphous silicon layer is approximately 2 times or more the throughput of the system 700 for depositing the first p-i-n junction comprising an intrinsic type microcrystalline silicon layer because the thickness of the intrinsic type microcrystalline silicon layer(s) is generally thicker than the intrinsic type amorphous silicon layer(s). Therefore, a single system 700 adapted to deposit a second p-i-n junction comprising intrinsic type amorphous silicon layer(s) can be matched with two or more systems 700 adapted to deposit a first p-i-n junction comprising intrinsic type microcrystalline silicon layer(s). Once a first p-i-n junction has been formed on one substrate in one system, the substrate may be exposed to the ambient environment (i.e., vacuum break) and transferred to the second system. A wet or dry cleaning of the substrate between the first system depositing the first p-i-n junction and the second p-i-n junction is not necessary.

While the foregoing is directed to embodiments of the present invention, other and further embodiments of the invention may be devised without departing from the basic scope thereof, and the scope thereof is determined by the claims that follow. For example, the process chamber of Figure 6 has been shown in a horizontal position. It is understood that in other embodiments of the invention the process chamber may be in any non-horizontal position, such as vertical. Embodiments of the invention have been described in reference to the multi-process chamber cluster tool in Figure 7, but in-line systems and hybrid in-line/cluster systems may also be used. Embodiments of the invention have been described in reference to a first system configured to form a first p-i-n junction and a second p-i-n junction, but the first p-i-n junction and a second p-i-n junction may also be formed in a single system. Embodiments of the invention have been described in reference to a process chamber adapted to deposit both an intrinsic type layer and an n-type layer, but separate chambers may be adapted to deposit the intrinsic type layer and the n-type layer, and a single process chamber may be adapted to deposit both a p-type layer and an intrinsic type layer. Finally, the embodiments described herein are p-i-n configurations generally applicable to transparent substrates, such as glass, but other embodiments are contemplated in which n-i-p junctions, single or multiply stacked, are constructed on opaque substrates such as stainless steel or polymer in a reverse deposition sequence.

## Claims

1. A method of making a solar cell, comprising:
forming an n-type crystalline semiconductor alloy layer (116, 224, 316, 424, 816, 922) over a substrate (101, 201, 301, 401, 801, 901); and
forming a conductive layer (118, 226, 318, 426, 818, 924) on the n-type crystalline semiconductor alloy layer.

2. The method of claim 1, wherein the n-type crystalline semiconductor alloy comprises one or more materials selected from the group consisting of silicon and germanium, and one or more materials selected from the group consisting of carbon, nitrogen, and oxygen.

3. The method of claim 1 or 2, wherein the n-type crystalline semiconductor alloy layer is formed by a process, comprising:
providing a carbon source and a silicon source to a processing chamber;
ionizing the carbon source and the silicon source by applying RF power; and
maintaining pressure of at least 8 Torr in the processing chamber.

4. The method of one of the claims 1 to 3, wherein the n-type crystalline semiconductor alloy layer has a refractive index of between about 1.5 and 3.6, a bandgap of at least 2 eV, and conductivity of at least 0.1 S/cm.

5. A method of forming a solar cell (300, 400, 800, 900), comprising:
forming a conductive layer (304, 404,804, 904) on a substrate (301, 401, 801, 901);
forming a first doped crystalline semiconductor alloy layer (306, 406, 806, 906) on the conductive layer; and
forming a second doped crystalline semiconductor alloy layer (316, 416, 418, 424, 810, 812, 816, 910, 912, 916, 918, 922) over the first doped semiconductor alloy layer.

6. The method of claim 5, wherein the first doped crystalline semiconductor layer is doped with a p-type dopant (306, 406, 806, 906), and the second doped crystalline semiconductor layer is doped with an n-type dopant (316, 424, 810, 816, 910, 916, 922).

7. The method of claim 5 or 6, wherein the first and second doped crystalline semiconductor alloy layers each comprises a semiconductive material and one or more materials selected from the group consisting of carbon, nitrogen, and oxygen.

8. The method of one of the claims 5 to 7, further comprising forming a first junction by forming an undoped crystalline semiconductor layer (312, 412, 808, 908) between the first and second doped crystalline semiconductor layers.

9. The method of claim 8, further comprising forming a second junction over the first junction, the second junction comprising a third doped crystalline semiconductor alloy layer (418, 812, 912, 918) and a fourth doped crystalline semiconductor alloy layer (424, 816, 916, 922), wherein the third doped crystalline semiconductor alloy layer is doped with a p-type dopant, and the fourth doped crystalline semiconductor alloy layer is doped with an n-type dopant.

10. A photovoltaic device, comprising:
an n-type crystalline semiconductor alloy layer (116, 224, 316, 424, 816, 922);
and
a conductive layer (118, 226, 318, 426, 818, 924) formed on the n-type crystalline semiconductor alloy layer.

11. The device of claim 10, wherein the n-type crystalline semiconductor alloy layer comprises one or more materials selected from the group consisting of carbon, nitrogen, and oxygen.

12. The device of claim 10 or 11, wherein the n-type crystalline semiconductor alloy layer has a refractive index of between about 1.5 and 3.6, a bandgap of at least 2 eV, and conductivity of at least 0.1 S/cm.

13. A photovoltaic device, comprising:
a conductive layer;
a first doped crystalline semiconductor alloy layer (306, 406, 806, 906) formed on the conductive layer; and
a second doped crystalline semiconductor alloy layer (316, 416, 418, 424, 810, 812, 816, 910, 912, 916, 918, 922) formed over the first doped crystalline semiconductor alloy layer.

14. The device of claim 13, wherein the first doped crystalline semiconductor alloy layer is an p-type layer (306, 406, 806, 906), and the second doped crystalline semiconductor alloy layer is a p-type layer (418, 812, 912, 918).

15. The device of claim 13 or 14, further comprising a first p-i-n junction over the first doped crystalline semiconductor alloy layer and a second p-i-n junction over the second doped crystalline semiconductor alloy layer.
